# EUROPÄISCHE PATENTANMELDUNG

(11) **EP 3 713 086 A1**
(43) Veröffentlichungstag der Anmeldung: **23.09.2020**
(21) Anmeldenummer: 19163389.0
(22) Anmeldetag: 18.03.2019
(51) Int. Cl.: H03K 17/0812, H03K 17/60, H03K 17/567

(54) **SCHUTZSCHALTUNG FÜR EINEN HALBLEITERSCHALTER**

(71) Anmelder: Siemens Aktiengesellschaft, 80333 München (DE)
(72) Erfinder: Stadter, Norbert, 96155 Buttenheim (DE)

(57) **Zusammenfassung**

Die Erfindung betrifft eine Schutzschaltung (9) für einen Halbleiterschalter (3). Die Schutzschaltung (9) umfasst eine Klemmdiode (D2), einen npn-Bipolartransistor (Q4), einen pnp-Bipolartransistor (Q3), einen Kondensator (C1) und mindestens drei Widerstände (R2,R4,R5). Die Bipolartransistoren (Q3,Q4) sind zu einer Thyristorstruktur verschaltet, die mit der Kathode der Klemmdiode (D2) verbunden ist. Ein erster Widerstand (R5) ist parallel zu der Basis-Emitter-Strecke des npn-Bipolartransistors (Q4) geschaltet. Ein erster Pol eines zweiten Widerstands (R2) ist mit der Basis des pnp-Bipolartransistors (Q3) verbunden. Der Kondensator (C1) ist parallel zu der Basis-Emitter-Strecke des pnp-Bipolartransistors (Q3) geschaltet. Ein dritter Widerstand (R4) ist entweder parallel zu der Basis-Emitter-Strecke des pnp-Bipolartransistors (Q3) geschaltet, oder ein erster Pol (R4_1) des dritten Widerstands (R4) ist mit dem Emitter des pnp-Bipolartransistors (Q3) verbunden und der zweite Pol (R4_2) des dritten Widerstands (R4) ist mit dem zweiten Pol (R2_2) des zweiten Widerstands (R2) verbunden.

## Beschreibung

Die Erfindung betrifft eine Schutzschaltung für einen Halbleiterschalter mit einem durch einen Gate-Treiber ansteuerbaren Gate und eine Schaltungsanordnung mit einer derartigen Schutzschaltung.

Mit dem Gate eines Halbleiterschalters wird der Steueranschluss des Halbleiterschalters bezeichnet. Die Erfindung dient vornehmlich dem Schutz eines spannungsgesteuerten Halbleiterschalters, beispielsweise eines Bipolartransistors mit isolierter Gate-Elektrode (IGBT) oder eines Metall-Oxid-Halbleiter-Feldeffekttransistors (MOSFET), der über eine an das Gate gelegte Gate-Spannung beziehungsweise ein Gate-Potential angesteuert wird. Bei einer zu hohen Verlustleistung, beispielsweise im Falle eines Kurzschlusses, kann der Halbleiterschalter beschädigt oder zerstört werden. Zur Vermeidung solcher Schäden muss sichergestellt werden, dass, beispielsweise im Kurzschlussfall, die Gate-Spannung nicht deutlich über ihren spezifizierten Einschaltwert steigt (Einhaltung der so genannten "safe operating area"). Andernfalls kann der Anstieg der Gate-Spannung zu einem zu hohen Strom durch den Halbleiterschalter, beispielsweise einem zu hohen Kollektor-Strom im Fall eines IGBT beziehungsweise Drain-Strom im Fall eines MOSFET, führen und die Verlustleistung zu stark erhöhen.

Um eine Überhöhung der Verlustleistung zu verhindern, kann beispielsweise eine Spannung an einem Lastanschluss des Halbleiterschalters, beispielsweise die Kollektor-Spannung im Fall eines IGBT oder die Drain-Spannung im Fall eines MOSFET, mittels einer Hochspannungsdiode oder eines Operationsverstärkers erfasst und überwacht werden. Alternativ kann ein Strom durch den Halbleiterschalter, beispielsweise mit einem Shunt oder einem Stromwandler, erfasst und überwacht werden. Diese Methoden ermöglichen jedoch teilweise keine ausreichend schnelle Abschaltung des Halbleiterschalters, da Potentialhürden überschritten werden müssen, sind aufwändig und kostspielig und/oder haben wegen Luft- und Kriechstrecken einen hohen Platzbedarf.

Der Erfindung liegt die Aufgabe zugrunde, eine verbesserte Schutzschaltung für einen Halbleiterschalter mit einem durch einen Gate-Treiber ansteuerbaren Gate und eine Schaltungsanordnung mit einer derartigen Schutzschaltung anzugeben.

Die Aufgabe wird erfindungsgemäß durch eine Schutzschaltung mit den Merkmalen des Anspruchs 1 und eine Schaltungsanordnung mit den Merkmalen des Anspruchs 5 gelöst.

Vorteilhafte Ausgestaltungen der Erfindung sind Gegenstand der Unteransprüche.

Eine erfindungsgemäße Schutzschaltung für einen Halbleiterschalter mit einem durch einen Gate-Treiber ansteuerbaren Gate umfasst eine Klemmdiode, einen npn-Bipolartransistor, einen pnp-Bipolartransistor, einen Kondensator und (mindestens) drei Widerstände. Der Kollektor des npn-Bipolartransistors ist mit der Basis des pnp-Bipolartransistors verbunden. Die Basis des npn-Bipolartransistors ist mit dem Kollektor des pnp-Bipolartransistors verbunden. Der Emitter des pnp-Bipolartransistors ist mit der Kathode der Klemmdiode verbunden. Ein erster Widerstand ist parallel zu der Basis-Emitter-Strecke des npn-Bipolartransistors geschaltet. Ein erster Pol eines zweiten Widerstands ist mit der Basis des pnp-Bipolartransistors verbunden. Der Kondensator ist parallel zu der Basis-Emitter-Strecke des pnp-Bipolartransistors geschaltet. Ein dritter Widerstand ist entweder parallel zu der Basis-Emitter-Strecke des pnp-Bipolartransistors geschaltet, oder ein erster Pol des dritten Widerstands ist mit dem Emitter des pnp-Bipolartransistors verbunden und der zweite Pol des dritten Widerstands ist mit dem zweiten Pol des zweiten Widerstands verbunden.

Eine erfindungsgemäße Schutzschaltung dient dem Schutz eines Halbleiterschalters vor zu hohen Verlustleistungen. Kernkomponenten der Schutzschaltung sind zwei zu einer Thyristorstruktur verschaltete Bipolartransistoren und eine Klemmdiode, deren Kathode mit dieser Thyristorstruktur verbunden ist. Die Schutzschaltung wird im Wesentlichen parallel zu einem Gate-Treiber über die Klemmdiode mit dem Gate des Halbleiterschalters verbunden. Dadurch wird ermöglicht, dass die Thyristorstruktur über die Klemmdiode gezündet wird, wenn die Gate-Spannung des Halbleiterschalters zu stark ansteigt und eine Entsättigung des Halbleiterschalters droht. Durch die Zündung der Thyristorstruktur kann der Halbleiterschalter temporär oder dauerhaft abgeschaltet werden oder die Gate-Spannung und ein Kurzschlussstrom durch den Halbleiterschalter können reduziert werden. Die Erfindung realisiert eine einfache Schutzschaltung mit sehr kostengünstigen Komponenten (zwei Bipolartransistoren, Widerstände, eine Klemmdiode, ein Kondensator und eventuell weitere einfache Komponenten), die einen nur geringen Platzbedarf haben. Die Schutzschaltung ermöglicht somit insbesondere einen kostengünstigen Schutz des Halbleiterschalters ohne einen aufwändigen Zugriff auf die Kollektor-Spannung oder den Kollektor-Strom.

Eine Ausgestaltung der Schutzschaltung sieht einen vierten Widerstand vor, der mit der Anode der Klemmdiode verbunden ist. Diese Ausgestaltung der Schutzschaltung ermöglicht eine Reduzierung der Gate-Spannung und eines durch den Halbleiterschalter fließenden Kurzschlussstroms, indem ein vierter Widerstand zwischen die Anode der Klemmdiode und das Gate des Halbleiterschalters geschaltet wird. Die Reduzierung des Kurzschlussstroms ermöglicht, einen Halbleiterschalter mit einer niedrigen Sättigungsspannung einzusetzen, bei dem ohne eine Reduzierung des Kurzschlussstroms eine Kurzschlusszeit nicht beherrscht werden kann. Durch die Reduzierung des Kurzschlussstroms kann der Halbleiterschalter einen Kurzschluss eine längere Zeitdauer schadlos überstehen, so dass während dieser Zeitdauer eine andere Überwachungsschaltung die Abschaltung des Halbleiterschalters einleiten kann.

Eine weitere Ausgestaltung der Schutzschaltung sieht eine Zusatzdiode vor, deren Kathode entweder direkt oder über einen fünften Widerstand mit dem Emitter des pnp-Bipolartransistors und der Kathode der Klemmdiode verbunden ist. Mit dieser Ausgestaltung der Schutzschaltung kann ein das Gate ansteuernder Gate-Treiber entlastet werden, indem eine Treiberspannung des Gate-Treibers an die Anode der Zusatzdiode gelegt wird.

Bei einer weiteren Ausgestaltung der Schutzschaltung ist die Klemmdiode eine Schottky-Diode. Eine Schottky-Diode eignet sich insbesondere durch ihre geringen Schaltzeiten als Klemmdiode für die Schutzschaltung.

Eine erfindungsgemäße Schaltungsanordnung umfasst einen Halbleiterschalter mit einem Gate, einen Gate-Treiber zum Ansteuern des Gate's und eine erfindungsgemäße Schutzschaltung. Der Gate-Treiber weist eine durch eine Treiberspannung des Gate-Treibers steuerbare elektronische Schalteinheit auf, mit der das Gate zum Einschalten des Halbleiterschalters über einen Einschalt-Gatewiderstand mit einem Einschaltpotential und zum Ausschalten des Halbleiterschalters über einen Ausschalt-Gatewiderstand mit einem Ausschaltpotential verbunden wird. Die Vorteile der erfindungsgemäßen Schaltungsanordnung ergeben sich aus den oben bereits genannten Vorteilen einer erfindungsgemäßen Schutzschaltung.

Bei einer Ausgestaltung der Schaltungsanordnung ist der Emitter des npn-Bipolartransistors mit dem Ausschaltpotential verbunden und der zweite Pol des zweiten Widerstands ist mit dem Einschaltpotential verbunden. Auf diese Weise wird die Schutzschaltung parallel zu den Komponenten des Gate-Treibers zwischen das Einschaltpotential und das Ausschaltpotential geschaltet.

Bei einer weiteren Ausgestaltung der Schaltungsanordnung ist die Anode der Klemmdiode direkt oder über einen vierten Widerstand mit dem Gate verbunden. Wie bereits oben ausgeführt wurde, kann durch den vierten Widerstand insbesondere vorteilhaft der Kurzschlussstrom durch den Halbleiterschalter reduziert werden.

Eine weitere Ausgestaltung der Schaltungsanordnung sieht eine Zusatzdiode vor, deren Kathode direkt oder über einen fünften Widerstand mit dem Emitter des pnp-Bipolartransistors und der Kathode der Klemmdiode verbunden ist und an deren Anode die Treiberspannung liegt. Wie bereits oben ausgeführt wurde, kann durch die Zusatzdiode der Gate-Treiber entlastet werden.

Bei einer weiteren Ausgestaltung der Schaltungsanordnung sind der Einschalt-Gatewiderstand und der Ausschalt-Gatewiderstand identisch. Dadurch kann die Bauteilanzahl der Schaltungsanordnung verringert werden, indem derselbe Gatewiderstand zum Einschalten und Ausschalten des Halbleiterschalters verwendet wird.

Bei einer weiteren Ausgestaltung der Schaltungsanordnung ist zwischen den Einschalt-Gatewiderstand und den Gate-Treiber eine Vorschaltdiode geschaltet, deren Kathode mit dem Einschalt-Gatewiderstand verbunden ist.

Bei weiteren Ausgestaltungen der Schaltungsanordnung ist der Halbleiterschalter ein Bipolartransistor mit isolierter Gate-Elektrode (IGBT) oder ein Metall-Oxid-Halbleiter-Feldeffekttransistor (MOSFET). Diese Ausgestaltungen der Schaltungsanordnung berücksichtigen, dass sowohl ein IGBT als auch ein MOSFET vorteilhaft durch eine erfindungsgemäße Schutzschaltung geschützt werden können.

Bei weiteren Ausgestaltungen der Schaltungsanordnung weist die elektronische Schalteinheit des Gate-Treibers eine Gegentaktendstufe mit Endstufen-Bipolartransistoren oder eine Endstufe mit komplementären Endstufen-Metall-Oxid-Halbleiter-Feldeffekttransistoren auf. Diese Ausgestaltungen der Schaltungsanordnung berücksichtigen, dass eine erfindungsgemäße Schutzschaltung in Verbindung mit beiden genannten Typen von Gate-Treibern eingesetzt werden kann.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein erstes Ausführungsbeispiel einer erfindungsgemäßen Schaltungsanordnung,
- FIG 2: zeitliche Verläufe von Strömen und Spannungen der in FIG 1 gezeigten Schaltungsanordnung im Fall, dass der Halbleiterschalter nach dem Einschalten an seine Entsättigungsgrenze kommt,
- FIG 3: zeitliche Verläufe von Strömen und Spannungen der in FIG 1 gezeigten Schaltungsanordnung im Fall, dass der Halbleiterschalter nach einem zweiten Einschalten an seine Entsättigungsgrenze kommt,
- FIG 4: ein zweites Ausführungsbeispiel einer erfindungsgemäßen Schaltungsanordnung,
- FIG 5: zeitliche Verläufe von Strömen und Spannungen der in FIG 4 gezeigten Schaltungsanordnung im Fall, dass der Halbleiterschalter nach dem Einschalten an seine Entsättigungsgrenze kommt,
- FIG 6: zeitliche Verläufe von Strömen und Spannungen der in FIG 4 gezeigten Schaltungsanordnung im Fall, dass der Halbleiterschalter nach einem zweiten Einschalten an seine Entsättigungsgrenze kommt,
- FIG 7: ein drittes Ausführungsbeispiel einer erfindungsgemäßen Schaltungsanordnung,
- FIG 8: zeitliche Verläufe von Strömen und Spannungen der in FIG 7 gezeigten Schaltungsanordnung im Fall, dass der Halbleiterschalter nach dem Einschalten an seine Entsättigungsgrenze kommt,
- FIG 9: ein viertes Ausführungsbeispiel einer erfindungsgemäßen Schaltungsanordnung,
- FIG 10: zeitliche Verläufe von Strömen und Spannungen der in FIG 9 gezeigten Schaltungsanordnung im Fall, dass der Halbleiterschalter bei zwei aufeinander folgenden Einschaltphasen jeweils an seine Entsättigungsgrenze kommt.

Einander entsprechende Teile sind in den Figuren mit denselben Bezugszeichen versehen.

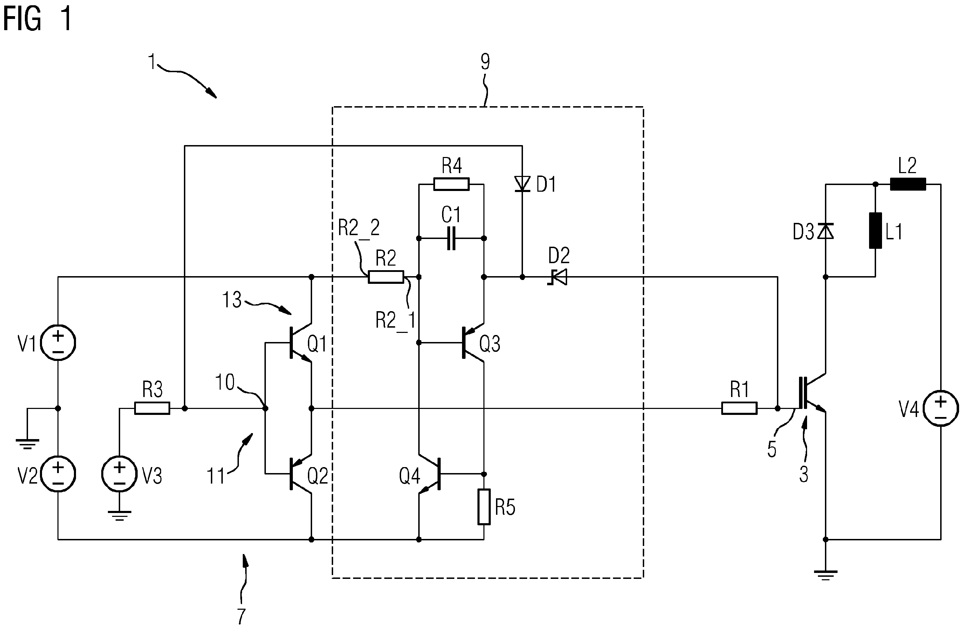

FIG 1 zeigt ein erstes Ausführungsbeispiel einer erfindungsgemäßen Schaltungsanordnung 1. Die Schaltungsanordnung 1 umfasst einen Halbleiterschalter 3 mit einem Gate 5, einen Gate-Treiber 7 zum Ansteuern des Gate 5 und ein erstes Ausführungsbeispiel einer erfindungsgemäßen Schutzschaltung 9. Der Halbleiterschalter 3 dieses Ausführungsbeispiels ist ein IGBT.

Der Gate-Treiber 7 weist eine elektronische Schalteinheit 11 auf, die über einen Gatewiderstand R1 mit dem Gate 5 verbunden ist. Der Gatewiderstand R1 dient als Einschalt-Gatewiderstand beim Einschalten des Halbleiterschalters 3 und als Ausschalt-Gatewiderstand beim Ausschalten des Halbleiterschalters 3.

Mit der elektronischen Schalteinheit 11 wird das Gate 5 über den Gatewiderstand R1 zum Einschalten des Halbleiterschalters 3 mit einem Einschaltpotential und zum Ausschalten des Halbleiterschalters mit einem Ausschaltpotential verbunden. Das Einschaltpotential wird von einer Einschaltspannungsquelle V1 erzeugt. Das Ausschaltpotential wird von einer Ausschaltspannungsquelle V2 erzeugt. Die elektronische Schalteinheit 11 wird durch eine Treiberspannung gesteuert. Die Treiberspannung wird von einer Treiberspannungsquelle V3 über einen Treiberwiderstand R3 an einen Steuereingang 10 der elektronischen Schalteinheit 11 gelegt. Die Spannungsquellen V1, V2, V3 sind jeweils Gleichspannungsquellen.

Die Schutzschaltung 9 umfasst eine Klemmdiode D2, einen pnp-Bipolartransistor Q3, einen npn-Bipolartransistor Q4, einen Kondensator C1, einen ersten Widerstand R5, einen zweiten Widerstand R2, einen dritten Widerstand R4 und eine Zusatzdiode D1.

Der Kollektor des npn-Bipolartransistors Q4 ist mit der Basis des pnp-Bipolartransistors Q3 verbunden. Die Basis des npn-Bipolartransistors Q4 ist mit dem Kollektor des pnp-Bipolartransistors Q3 verbunden. Damit sind der pnp-Bipolartransistor Q3 und der npn-Bipolartransistor Q4 zu einer Thyristorstruktur verschaltet.

Der erste Widerstand R5 ist parallel zu der Basis-Emitter-Strecke des npn-Bipolartransistors Q4 geschaltet. Ein erster Pol R2_1 des zweiten Widerstands R2 ist mit der Basis des pnp-Bipolartransistors Q3 verbunden. Der zweite Pol R2_2 des zweiten Widerstands R2 ist mit dem Einschaltpotential verbunden, das heißt mit dem positiven Pol der Einschaltspannungsquelle V1. Der Kondensator C1 und der dritte Widerstand R4 sind parallel zu der Basis-Emitter-Strecke des pnp-Bipolartransistors Q3 geschaltet.

Die Kathode der Klemmdiode D2 ist mit dem Emitter des pnp-Bipolartransistors Q3 verbunden. Die Anode der Klemmdiode D2 ist mit dem Gate 5 des Halbleiterschalters 3 verbunden. Die Kathode der Zusatzdiode D1 ist mit dem Emitter des pnp-Bipolartransistors Q3 und der Kathode der Klemmdiode D2 verbunden. An der Anode der Zusatzdiode D1 liegt die Treiberspannung an, das heißt die Anode der Zusatzdiode D1 ist mit dem Steuereingang 10 der elektronischen Schalteinheit 11 verbunden.

Bei dem in FIG 1 gezeigten Ausführungsbeispiel weist die elektronische Schalteinheit 11 eine Gegentaktendstufe 13 mit Endstufen-Bipolartransistoren Q1, Q2 auf. Die Klemmdiode D2 ist eine Schottky-Diode. Der Gatewiderstand R1 hat beispielsweise einen Widerstandswert von 10 Ω. Der Treiberwiderstand R3 hat beispielsweise einen Widerstandswert von 470 Ω. Der erste Widerstand R5 hat beispielsweise einen Widerstandswert von 200 Ω. Der zweite Widerstand R2 hat beispielsweise einen Widerstandswert von 1 kΩ. Der dritte Widerstand R4 hat beispielsweise einen Widerstandswert von 10 kΩ. Der Kondensator C1 hat beispielsweise eine Kapazität von 1 nF.

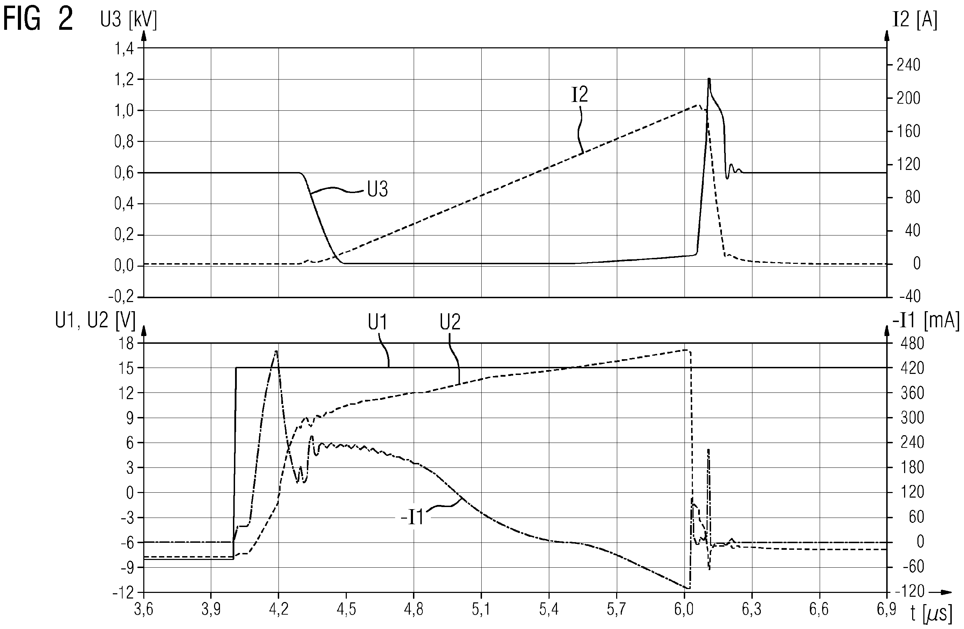

FIG 2 zeigt Verläufe von Strömen I1, I2 und Spannungen U1, U2, U3 der in FIG 1 gezeigten Schaltungsanordnung 1 in Abhängigkeit von einer Zeit t im Fall, dass der Halbleiterschalter 3 nach dem Einschalten an seine Entsättigungsgrenze kommt. Die Verläufe wurden mit einer Simulation erzeugt, bei der der Halbleiterschalter 3 wie in FIG 1 gezeigt mit einer Halbbrückendiode D3 und einer Streuinduktivität L2 zu einer Halbbrücke verschaltet ist und eine mit der Halbbrücke verbundene Last durch eine Lastinduktivität L1 und eine Lastspannungsquelle V4 simuliert wurde. Die Lastspannungsquelle V4 ist eine Gleichspannungsquelle. Die Anode der Halbbrückendiode D3 ist mit dem Kollektor des Halbleiterschalters 3 verbunden, die Lastinduktivität L1 ist parallel zu der Halbbrückendiode D3 geschaltet, die Streuinduktivität L2 ist zwischen die Parallelschaltung der Halbbrückendiode D3 und der Lastinduktivität L1 und den positiven Pol der Lastspannungsquelle V4 geschaltet, und der negative Pol der Lastspannungsquelle V4 ist mit dem Emitter des Halbleiterschalters 3 verbunden. Der Emitter des Halbleiterschalters 3 ist mit den negativen Polen der Spannungsquellen V1 und V3 und dem positiven Pol der Spannungsquelle V2 verbunden, das heißt liegt auf demselben Erdpotential wie diese Pole. Die Spannungen U1, U2, U3 sind jeweils auf das Erdpotential bezogen, wobei U1 das Treibersignal des Gate-Treibers 7 ist, das heißt die von der Treiberspannungsquelle V3 gegenüber dem Erdpotential erzeugte Spannung, U2 die an dem Gate 5 anliegende Gate-Spannung gegenüber dem Erdpotential ist und U3 die an dem Kollektor des Halbleiterschalters 3 anliegende Kollektor-Spannung gegenüber dem Erdpotential ist.

Die Simulation wurde für einen Gatewiderstand R1 von 10 Ω, einen Treiberwiderstand R3 von 470 Ω, einen ersten Widerstand R5 von 200 Ω, einen zweiten Widerstand R2 von 1 kΩ, einen dritten Widerstand R4 von 10 kΩ, einen Kondensator C1 mit der Kapazität 1 nF, eine Lastinduktivität L1 von 5 µH und eine Streuinduktivität L2 von 200 nH durchgeführt.

Etwa 4 µs nach dem Beginn der Simulation wird zum Einschalten des Halbleiterschalters 3 ein Treibersignal U1 des Gate-Treibers 7 von einem Ausschaltwert -8 V auf einen Einschaltwert 15 V erhöht. Als Folge davon steigt eine an dem Gate 5 anliegende Gate-Spannung U2 von einem Ausschalt-Gate-Spannungswert, der etwa mit dem Ausschaltwert des Treibersignals U1 übereinstimmt, an und es bildet sich ein durch den Gatewiderstand R1 fließender Reaktionsstrom I1, der in FIG 2 mit invertiertem Vorzeichen dargestellt ist. Mit steigender Gate-Spannung U2 sinkt eine an dem Kollektor des Halbleiterschalters 3 anliegende Kollektor-Spannung U3 von 0,6 kV auf nahezu 0 V und es bildet sich ein zwischen dem Kollektor und dem Emitter des Halbleiterschalters 3 fließender Kollektor-Strom I2, der linear aufgrund der Lastinduktivität L1 ansteigt.

Der Reaktionsstrom I1 nimmt betragsmäßig nach der Änderung des Treibersignals U1 zunächst zu und anschließend bei steigender Gate-Spannung U2 wieder ab. Etwa 5,5 µs nach dem Beginn der Simulation ändert der Reaktionsstrom I1 seine Richtung (beziehungsweise sein Vorzeichen), da sich die Millerkapazität des Halbleiterschalters 3 auflädt und der Reaktionsstrom I1 in das Gate 5 zurückfließt. Mit steigendem Kollektor-Strom I2 kommt der Halbleiterschalter 3 etwa 5,8 µs nach dem Beginn der Simulation an seine Entsättigungsgrenze und die Kollektor-Spannung U3 beginnt (zunächst langsam) wieder zu steigen. Aufgrund der Millerkapazität des Halbleiterschalters 3 steigt die Gate-Spannung U2 über den Einschaltwert 15 V des Treibersignals U1 und der Betrag des in das Gate 5 zurückfließenden Reaktionsstroms I1 nimmt zu. Etwas später als 6 µs nach dem Beginn der Simulation wird schließlich über die Klemmdiode D2 die von dem pnp-Bipolartransistor Q3 und dem npn-Bipolartransistor Q4 gebildete Thyristorstruktur gezündet, wodurch sich die Gate-Spannung U2 dem Ausschalt-Gate-Spannungswert annähert, der Reaktionsstrom I1 und der Kollektor-Strom I2 wieder auf Null abfallen, die Kollektor-Spannung U3 ihren Ausgangswert 0,6 kV annimmt und der Halbleiterschalter 3 abgeschaltet wird.

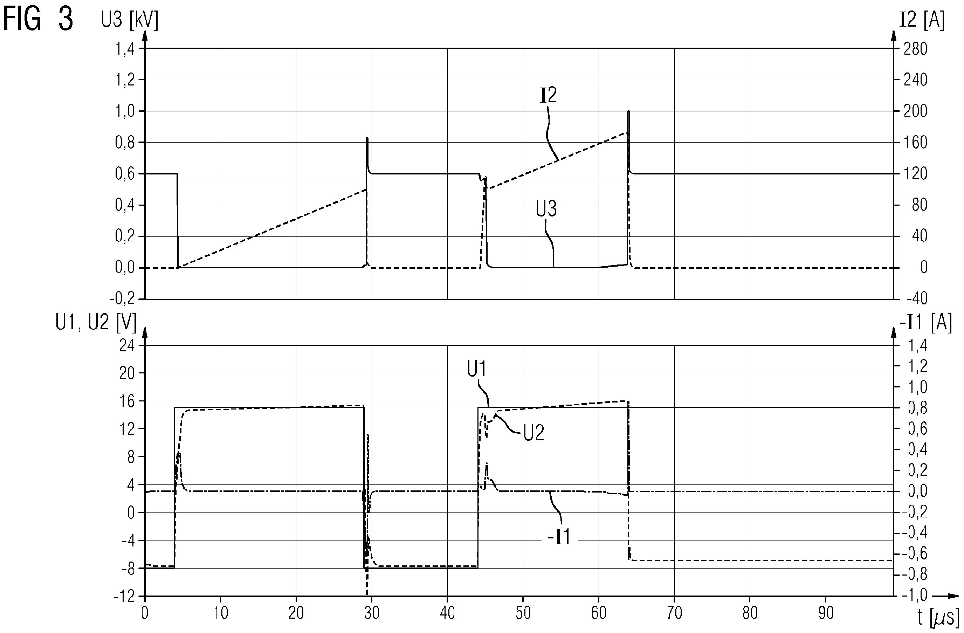

FIG 3 zeigt analog zu FIG 2 zeitliche Verläufe der Ströme I1, I2 und Spannungen U1, U2, U3 der in FIG 1 gezeigten Schaltungsanordnung 1 im Fall, dass der Halbleiterschalter 3 nach einem zweiten Einschalten an seine Entsättigungsgrenze kommt. Die Verläufe wurden mit einer Simulation erzeugt, bei der im Unterschied zu der in FIG 2 gezeigten Simulation die Lastinduktivität L1 den Induktivitätswert 150 µH aufweist. Davon abgesehen liegen der Simulation dieselben Parameter zugrunde wie der in FIG 2 gezeigten Simulation.

Der Halbleiterschalter 3 wird etwa 4 µs nach dem Beginn der Simulation eingeschaltet, indem das Treibersignal U1 des Gate-Treibers 7 von dem Ausschaltwert -8 V auf den Einschaltwert 15 V erhöht wird, und etwa 29 µs nach dem Beginn der Simulation wieder abgeschaltet, indem das Treibersignal U1 wieder auf den Ausschaltwert -8 V gesenkt wird. Während dieser ersten Einschaltphase steigt die Gate-Spannung U2 nur unwesentlich über den Einschaltwert 15 V, so dass die von dem pnp-Bipolartransistor Q3 und dem npn-Bipolartransistor Q4 gebildete Thyristorstruktur nicht gezündet wird.

Etwa 44 µs nach dem Beginn der Simulation wird der Halbleiterschalter 3 ein zweites Mal eingeschaltet. In dieser zweiten Einschaltphase steigt der Kollektor-Strom I2 nach dem Einschalten schnell auf etwa den gleichen Wert wie am Ende der ersten Einschaltphase, und die Gate-Spannung U2 steigt deutlicher über den Einschaltwert 15 V als in der ersten Einschaltphase, wodurch der Reaktionsstrom I1 in das Gate 5 zurückfließt, die von dem pnp-Bipolartransistor Q3 und dem npn-Bipolartransistor Q4 gebildete Thyristorstruktur nach etwa 64 µs zündet und der Halbleiterschalter 3 abgeschaltet wird.

Die Figuren 2 und 3 zeigen, dass die in FIG 1 gezeigte Schutzschaltung 9 eine Abschaltung des Halbleiterschalters 3 durch Zünden der von dem pnp-Bipolartransistor Q3 und dem npn-Bipolartransistor Q4 gebildeten Thyristorstruktur bewirkt, wenn das Treibersignal U1 solange auf dem Einschaltwert 15 V liegt, dass der Halbleiterschalter 3 an seine Entsättigungsgrenze kommt.

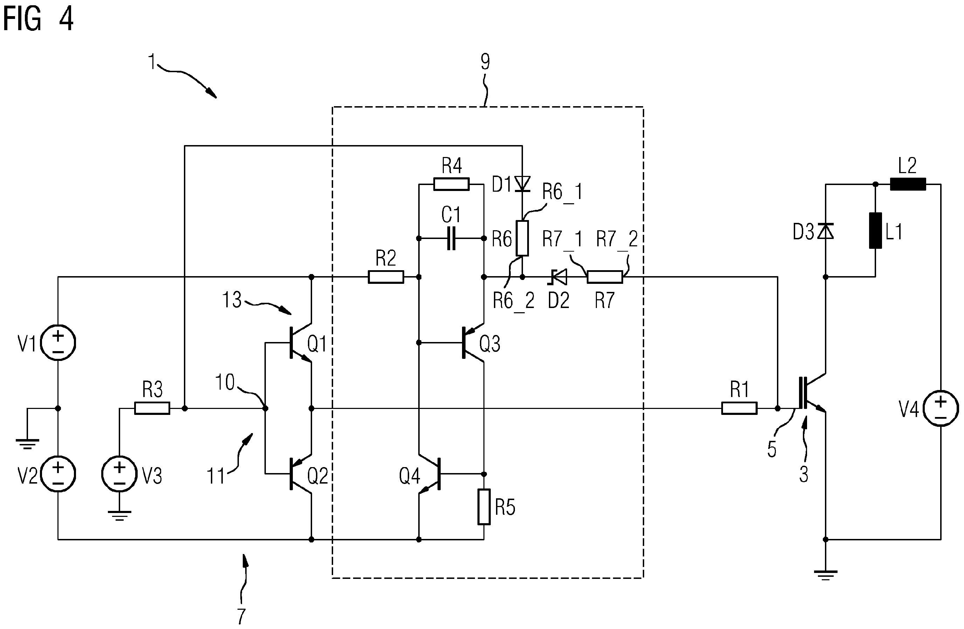

FIG 4 zeigt ein zweites Ausführungsbeispiel einer erfindungsgemäßen Schaltungsanordnung 1. Die Schaltungsanordnung 1 unterscheidet sich von der in FIG 1 gezeigten Schaltungsanordnung 1 lediglich dadurch, dass die Schutzschaltung 9 zusätzlich zu den Komponenten der in FIG 1 gezeigten Schutzschaltung 9 einen vierten Widerstand R7 und einen fünften Widerstand R6 aufweist. Ein erster Pol R7_1 des vierten Widerstands R7 ist mit der Anode der Klemmdiode D2 verbunden. Der zweite Pol R7_2 des vierten Widerstands R7 ist mit dem Gate 5 und dem gateseitigen Pol des Gate-Widerstands R1 verbunden. Ein erster Pol R6_1 des fünften Widerstands R6 ist mit der Kathode der Zusatzdiode D1 verbunden. Der zweite Pol R6 2 des fünften Widerstands R6 ist mit dem Emitter des pnp-Bipolartransistors Q3 und der Kathode der Klemmdiode D2 verbunden.

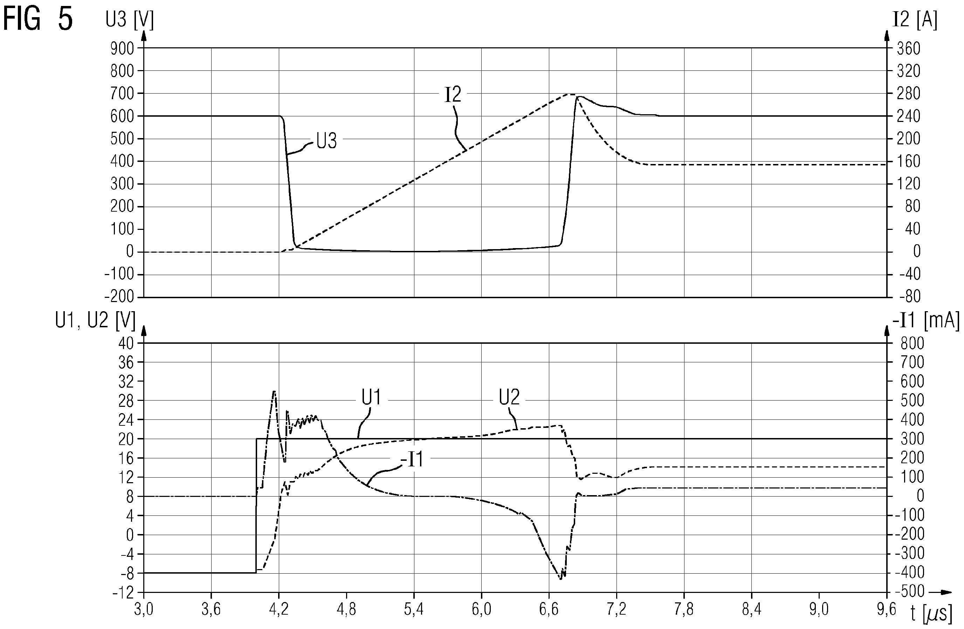

FIG 5 zeigt zeitliche Verläufe der Ströme I1, I2 und Spannungen U1, U2, U3 der in FIG 4 gezeigten Schaltungsanordnung 1 bei einer Simulation, die analog zu der in FIG 2 gezeigten Simulation ist. Wie bei der in FIG 2 gezeigten Simulation wurde die in FIG 5 gezeigte Simulation für einen Gatewiderstand R1 von 10 Ω, einen Treiberwiderstand R3 von 470 Ω, einen zweiten Widerstand R2 von 1 kΩ, einen dritten Widerstand R4 von 10 kΩ, einen Kondensator C1 mit der Kapazität 1 nF, eine Lastinduktivität L1 von 5 µH und eine Streuinduktivität L2 von 200 nH durchgeführt. Im Unterschied zu der in FIG 2 gezeigten Simulation wurde die in FIG 5 gezeigte Simulation für einen ersten Widerstand R5 von 1 kΩ und mit einem vierten Widerstand R7 von 470 Ω und einem fünften Widerstand R6 von 2,2 kΩ durchgeführt.

Etwa 4 µs nach dem Beginn der Simulation wird zum Einschalten des Halbleiterschalters 3 das Treibersignal U1 des Gate-Treibers 7 von einem Ausschaltwert -8 V auf einen Einschaltwert 20 V erhöht. Wie bei der in FIG 2 gezeigten Simulation steigt daraufhin die Gate-Spannung U2 an und es bildet sich ein durch den Gatewiderstand R1 fließender Reaktionsstrom I1. Mit steigender Gate-Spannung U2 sinkt die Kollektor-Spannung U3 von 0,6 kV auf nahezu 0 V und es bildet sich ein zwischen dem Kollektor und dem Emitter des Halbleiterschalters 3 fließender Kollektor-Strom I2, der linear aufgrund der Lastinduktivität L1 ansteigt.

Der Reaktionsstrom I1 nimmt betragsmäßig nach der Änderung des Treibersignals U1 zunächst zu und anschließend bei steigender Gate-Spannung U2 wieder ab. Etwa 5,5 µs nach dem Beginn der Simulation ändert der Reaktionsstrom I1 seine Richtung (beziehungsweise sein Vorzeichen), da sich die Millerkapazität des Halbleiterschalters 3 auflädt und der Reaktionsstrom I1 in das Gate 5 zurückfließt. Mit steigendem Kollektor-Strom I2 kommt der Halbleiterschalter 3 etwa 6 µs nach dem Beginn der Simulation an seine Entsättigungsgrenze und die Kollektor-Spannung U3 beginnt wieder anzusteigen. Aufgrund der Millerkapazität des Halbleiterschalters 3 steigt die Gate-Spannung U2 über den Einschaltwert 20 V des Treibersignals U1 und der Betrag des in das Gate 5 zurückfließenden Reaktionsstroms I1 nimmt zu. Etwa 6,7 µs nach dem Beginn der Simulation wird über die Klemmdiode D2 die von dem pnp-Bipolartransistor Q3 und dem npn-Bipolartransistor Q4 gebildete Thyristorstruktur gezündet. Durch die gegenüber der in FIG 1 gezeigten Schutzschaltung 9 hinzugefügten Widerstände R6, R7 wird der Halbleiterschalter 3 nach der Zündung der Bipolartransistoren Q3, Q4 jedoch im Unterschied zu FIG 2 nicht abgeschaltet, sondern die Gate-Spannung U2 wird auf etwa 15 V gesenkt, wodurch der Kollektor-Strom I2 auf einen Kurzschlussstrom von etwa 160 A reduziert wird.

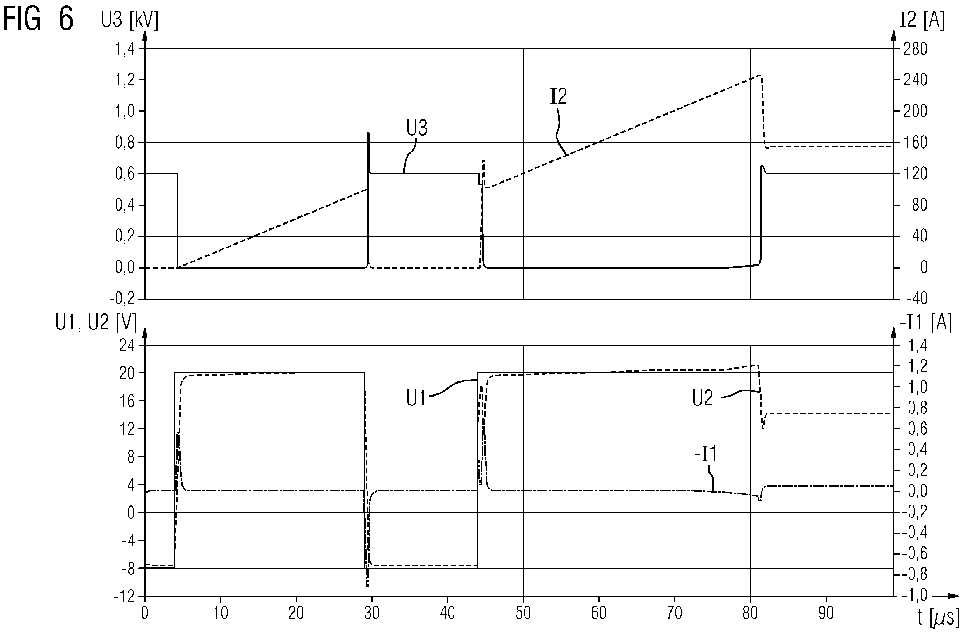

FIG 6 zeigt zeitliche Verläufe der Ströme I1, I2 und Spannungen U1, U2, U3 der in FIG 4 gezeigten Schaltungsanordnung 1 bei einer Simulation, die analog zu der in FIG 3 gezeigten Simulation ist. Die Verläufe wurden mit einer Simulation erzeugt, bei der im Unterschied zu der in FIG 4 gezeigten Simulation die Lastinduktivität L1 den Induktivitätswert 150 µH aufweist. Davon abgesehen liegen der Simulation dieselben Parameter zugrunde wie der in FIG 4 gezeigten Simulation.

Der Halbleiterschalter 3 wird etwa 4 µs nach dem Beginn der Simulation eingeschaltet, indem das Treibersignal U1 des Gate-Treibers 7 von dem Ausschaltwert -8 V auf den Einschaltwert 20 V erhöht wird, und etwa 29 µs nach dem Beginn der Simulation wieder abgeschaltet, indem das Treibersignal U1 wieder auf den Ausschaltwert -8 V gesenkt wird. Während dieser ersten Einschaltphase steigt die Gate-Spannung U2 nur unwesentlich über den Einschaltwert 20 V, so dass die von dem pnp-Bipolartransistor Q3 und dem npn-Bipolartransistor Q4 gebildete Thyristorstruktur nicht zündet.

Etwa 44 µs nach dem Beginn der Simulation wird der Halbleiterschalter 3 ein zweites Mal eingeschaltet. In dieser zweiten Einschaltphase steigt der Kollektor-Strom I2 nach dem Einschalten schnell auf etwa den gleichen Wert wie am Ende der ersten Einschaltphase, und die Gate-Spannung U2 steigt deutlicher über den Einschaltwert 20 V als in der ersten Einschaltphase, wodurch der Reaktionsstrom I1 in das Gate 5 zurückfließt und die von dem pnp-Bipolartransistor Q3 und dem npn-Bipolartransistor Q4 gebildete Thyristorstruktur nach etwa 81 µs zündet. Analog zu FIG 5 sinkt die Gate-Spannung U2 nach dem Zünden der Bipolartransistoren Q3, Q4 auf etwa 15 V, wodurch der Kollektor-Strom I2 auf einen Kurzschlussstrom von etwa 160 A reduziert wird.

Die Figuren 5 und 6 zeigen, dass die in FIG 4 gezeigte Schutzschaltung 9 Reduzierungen der Gate-Spannung U2 und des Kollektor-Stroms I2 bewirkt, wenn eine Entsättigung des Halbleiterschalters 3 droht. Der reduzierte Kollektor-Strom I2 kann dann mit einer langsameren Überwachungsschaltung, die beispielsweise eine Strommessung mit einer Potentialtrennung und einer Analog-Digitalwandlung umfasst, abgeschaltet werden.

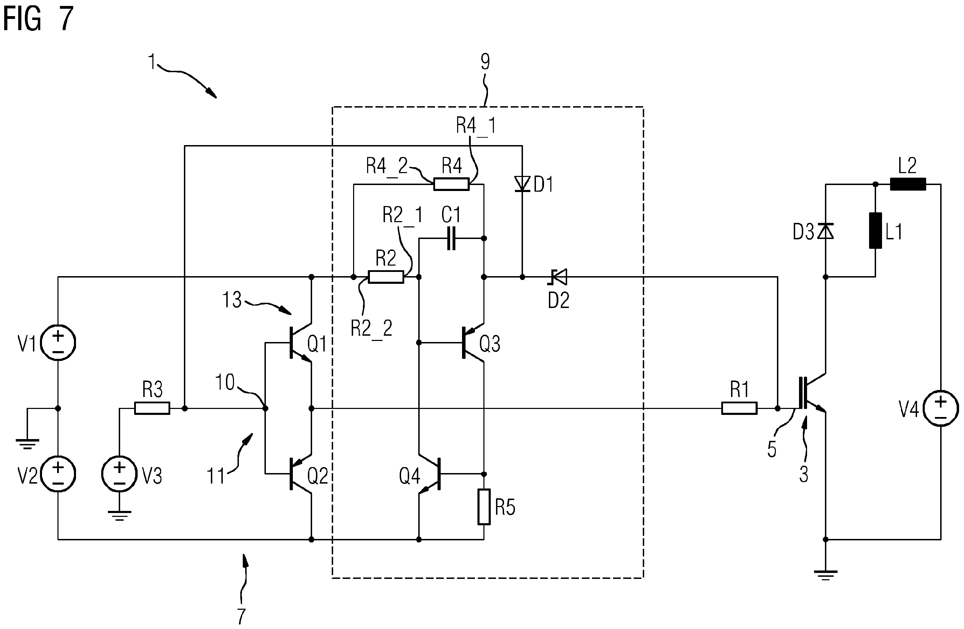

FIG 7 zeigt ein drittes Ausführungsbeispiel einer erfindungsgemäßen Schaltungsanordnung 1. Die Schaltungsanordnung 1 unterscheidet sich von der in FIG 1 gezeigten Schaltungsanordnung 1 lediglich dadurch, dass der dritte Widerstand R4 nicht parallel zu dem Kondensator C1 geschaltet ist, sondern dass ein erster Pol R4_1 des dritten Widerstands R4 mit dem Emitter des pnp-Bipolartransistors Q3 verbunden ist und der zweite Pol R4_2 des dritten Widerstands R4 mit dem zweiten Pol R2 2 des zweiten Widerstands R2 verbunden ist und damit auf dem Einschaltpotential liegt.

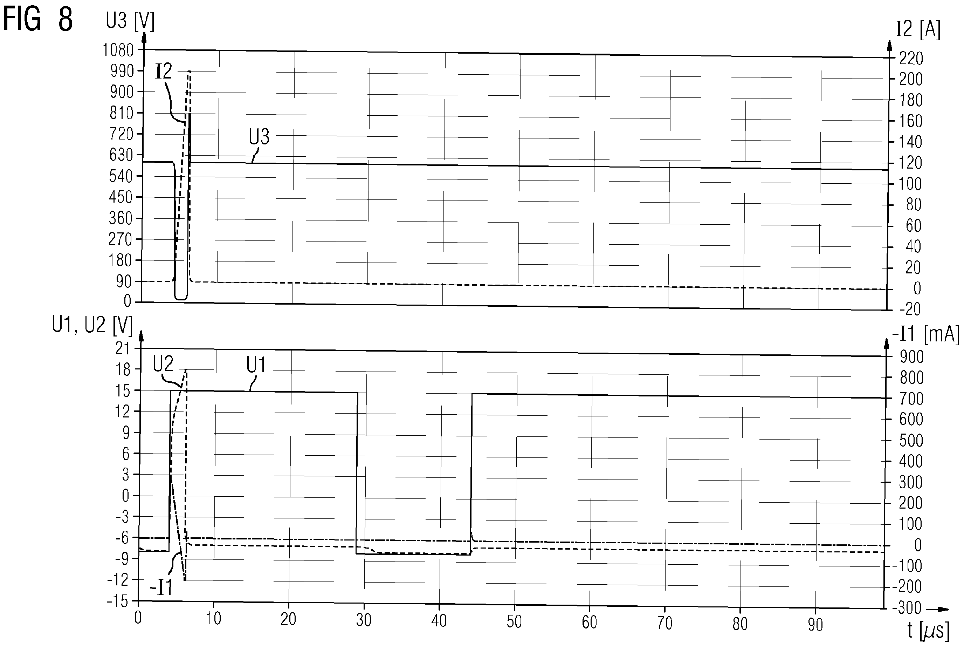

FIG 8 zeigt zeitliche Verläufe der Ströme I1, I2 und Spannungen U1, U2, U3 der in FIG 7 gezeigten Schaltungsanordnung 1 bei einer Simulation, die analog zu der in FIG 2 gezeigten Simulation ist. Wie bei der in FIG 2 gezeigten Simulation wurde die in FIG 8 gezeigte Simulation für einen Gatewiderstand R1 von 10 Ω, einen Treiberwiderstand R3 von 470 Ω, einen ersten Widerstand R5 von 200 Ω, einen zweiten Widerstand R2 von 1 kΩ, eine Lastinduktivität L1 von 5 µH und eine Streuinduktivität L2 von 200 nH durchgeführt. Im Unterschied zu der in FIG 2 gezeigten Simulation wurde die in FIG 8 gezeigte Simulation für einen dritten Widerstand R4 von 2,2 kΩ und einen Kondensator C1 mit einer Kapazität von 2 nF durchgeführt.

Etwa 4 µs nach dem Beginn der Simulation wird zum Einschalten des Halbleiterschalters 3 das Treibersignal U1 des Gate-Treibers 7 von einem Ausschaltwert -8 V auf einen Einschaltwert 15 V erhöht. Wie bei der in FIG 2 gezeigten Simulation steigt daraufhin die Gate-Spannung U2 an und es bildet sich ein durch den Gatewiderstand R1 fließender Reaktionsstrom I1. Mit steigender Gate-Spannung U2 sinkt die Kollektor-Spannung U3 von 0,6 kV auf nahezu 0 V und es bildet sich ein zwischen dem Kollektor und dem Emitter des Halbleiterschalters 3 fließender Kollektor-Strom I2, der linear aufgrund der Lastinduktivität L1 ansteigt.

Der Reaktionsstrom I1 nimmt betragsmäßig nach der Änderung des Treibersignals U1 zunächst zu und anschließend bei steigender Gate-Spannung U2 wieder ab. Etwa 5,5 µs nach dem Beginn der Simulation ändert der Reaktionsstrom I1 seine Richtung (beziehungsweise sein Vorzeichen), da sich die Millerkapazität des Halbleiterschalters 3 auflädt und der Reaktionsstrom I1 in das Gate 5 zurückfließt. Etwa 5,8 µs nach dem Beginn der Simulation kommt der Halbleiterschalter 3 an seine Entsättigungsgrenze. Aufgrund der Millerkapazität des Halbleiterschalters 3 steigt die Gate-Spannung U2 über den Einschaltwert 15 V des Treibersignals U1 und der Betrag des in das Gate 5 zurückfließenden Reaktionsstroms I1 nimmt zu. Etwa 6 µs nach dem Beginn der Simulation zündet über die Klemmdiode D2 die von dem pnp-Bipolartransistor Q3 und dem npn-Bipolartransistor Q4 gebildete Thyristorstruktur, die Gate-Spannung U2 fällt auf den negativen Ausschalt-Gate-Spannungswert ab und der Halbleiterschalter 3 wird abgeschaltet. Der dritte Widerstand R4 sorgt für einen dauerhaften Haltestrom für die Bipolartransistoren Q3, Q4 der Schutzschaltung 9, so dass die Gate-Spannung U2 negativ bleibt, auch wenn das Treibersignal U1 auf den Ausschaltwert -8 V und anschließend wieder auf den Einschaltwert 15 V gesetzt wird.

FIG 8 zeigt, dass die in FIG 7 gezeigte Schutzschaltung 9 eine dauerhafte Abschaltung des Halbleiterschalters 3 durch das Zünden der Bipolartransistoren Q3, Q4 der Schutzschaltung 9 bewirkt, wenn der Halbleiterschalter 3 an seine Entsättigungsgrenze kommt.

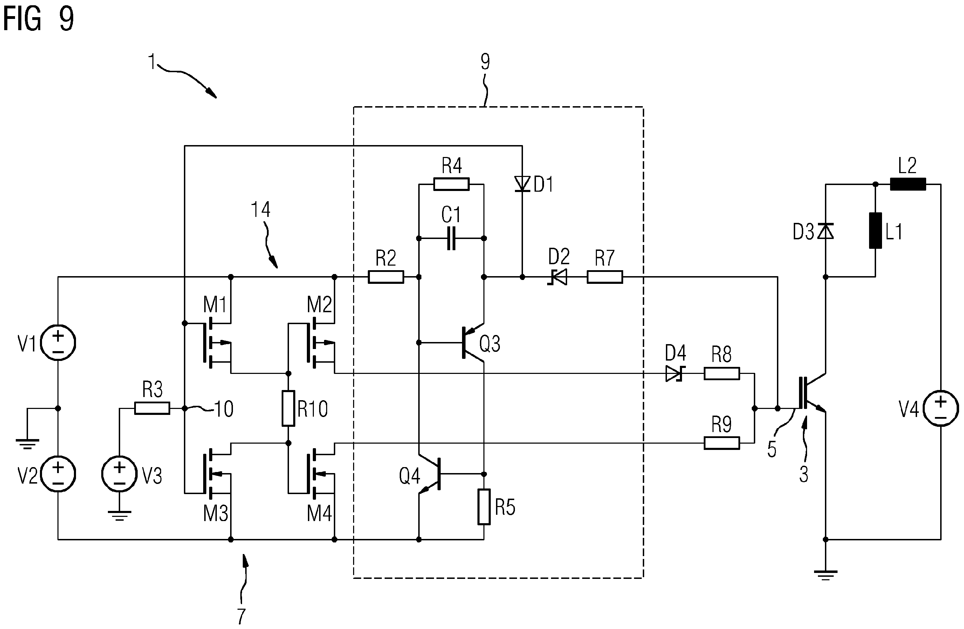

FIG 9 zeigt ein viertes Ausführungsbeispiel einer erfindungsgemäßen Schaltungsanordnung 1. Die Schaltungsanordnung 1 unterscheidet sich von der in FIG 1 gezeigten Schaltungsanordnung 1 zum einen durch einen vierten Widerstand R7, der zwischen die Anode der Klemmdiode D2 und das Gate 5 des Halbleiterschalters 3 geschaltet ist, und zum anderen durch die Ausführung der elektronischen Schalteinheit 11 und deren Verbindung mit dem Gate 5.

Die elektronische Schalteinheit 11 weist eine Endstufe 14 mit komplementären Endstufen-MOSFET M1 bis M4 statt einer Gegentaktendstufe 13 mit Endstufen-Bipolartransistoren Q1, Q2 auf. Ein erster Endstufen-MOSFET M1 und ein zweiter Endstufen-MOSFET M2 der Endstufe 14 sind jeweils als ein p-Kanal-MOSFET ausgebildet. Ein dritter Endstufen-MOSFET M3 und ein vierter Endstufen-MOSFET M4 der Endstufe 14 sind jeweils als ein n-Kanal-MOSFET ausgebildet. Die Gate-Anschlüsse des ersten Endstufen-MOSFET M1 und des dritten Endstufen-MOSFET M3 sind mit dem Steuereingang 10 der elektronischen Schalteinheit 11 verbunden. Der Drain-Anschluss des ersten Endstufen-MOSFET M1 ist mit dem Gate-Anschluss des zweiten Endstufen-MOSFET M2 verbunden. Der Drain-Anschluss des dritten Endstufen-MOSFET M3 ist mit dem Gate-Anschluss des vierten Endstufen-MOSFET M4 verbunden. Die Source-Anschlüsse des ersten Endstufen-MOSFET M1 und des zweiten Endstufen-MOSFET M2 liegen auf dem Einschaltpotential, das heißt diese Source-Anschlüsse sind mit dem positiven Pol der Einschaltspannungsquelle V1 verbunden. Die Source-Anschlüsse des dritten Endstufen-MOSFET M3 und des vierten Endstufen-MOSFET M4 liegen auf dem Ausschaltpotential, das heißt diese Source-Anschlüsse sind mit dem negativen Pol der Ausschaltspannungsquelle V2 verbunden. Der Drain-Anschluss des zweiten Endstufen-MOSFET M2 ist über eine Vorschaltdiode D4 und einen Einschalt-Gatewiderstand R8 mit dem Gate 5 des Halbleiterschalters 3 verbunden, wobei die Anode der Vorschaltdiode D4 mit dem Drain-Anschluss des zweiten Endstufen-MOSFET M2 verbunden ist und der Einschalt-Gatewiderstand R8 zwischen die Kathode der Vorschaltdiode D4 und das Gate 5 geschaltet ist. Der Drain-Anschluss des vierten Endstufen-MOSFET M4 ist über einen Ausschalt-Gatewiderstand R9 mit dem Gate 5 des Halbleiterschalters 3 verbunden. Die Drain-Anschlüsse des ersten Endstufen-MOSFET M1 und des dritten Endstufen-MOSFET M3 sind über einen Verbindungswiderstand R10 miteinander verbunden.

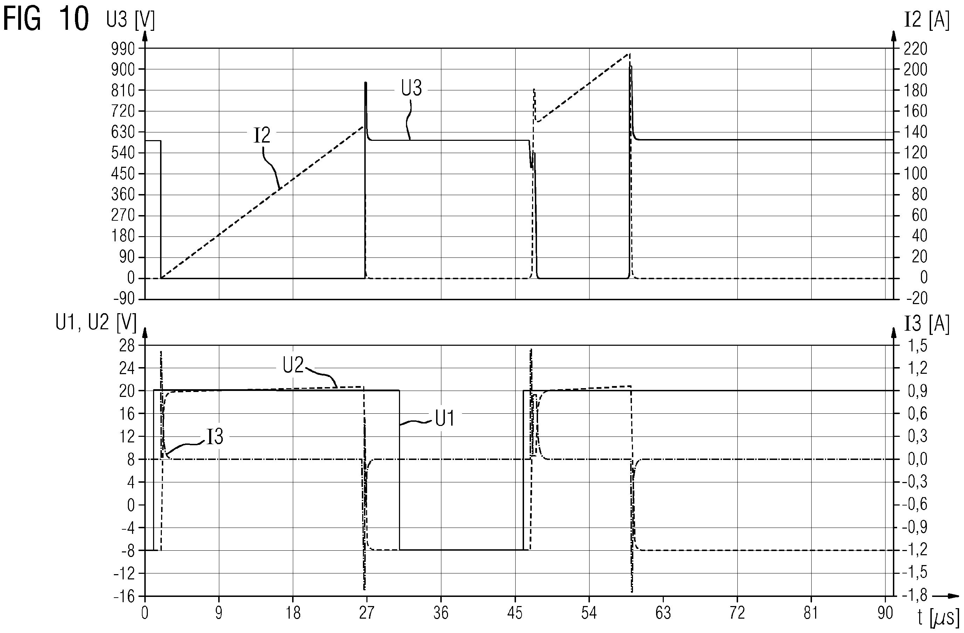

FIG 10 zeigt zeitliche Verläufe des Kollektor-Stroms I2, eines Gate-Stroms I3 durch das Gate 5 und der Spannungen U1, U2, U3 der in FIG 9 gezeigten Schaltungsanordnung 1 bei einer Simulation für einen Einschalt-Gatewiderstand R8 und einen Ausschalt-Gatewiderstand R9 von jeweils 10 Ω, einen Treiberwiderstand R3 von 470 Ω, einen ersten Widerstand R5 von 1 kΩ, einen zweiten Widerstand R2 von 470 Ω, einen dritten Widerstand R4 von 10 kΩ, einen vierten Widerstand R7 von 100 Ω, einen Verbindungswiderstand R10 von 50 Ω, einen Kondensator C1 mit einer Kapazität von 2 nF, eine Lastinduktivität L1 von 100 µH und eine Streuinduktivität L2 von 200 nH.

Etwa 1 µs nach dem Beginn der Simulation wird zum Einschalten des Halbleiterschalters 3 das Treibersignal U1 des Gate-Treibers 7 von einem Ausschaltwert -8 V auf einen Einschaltwert 20 V erhöht. Analog zu der in FIG 2 gezeigten Simulation steigt daraufhin die Gate-Spannung U2 an bis sie den Einschaltwert 20 V so deutlich überschreitet, dass die von dem pnp-Bipolartransistor Q3 und dem npn-Bipolartransistor Q4 der Schutzschaltung 9 gebildete Thyristorstruktur zündet, die Gate-Spannung U2 wieder auf den Ausschalt-Gate-Spannungswert von etwa -8 V abfällt und der Halbleiterschalter 3 abgeschaltet wird. Etwa 31 µs nach dem Beginn der Simulation wird das Treibersignal U1 auf den Ausschaltwert -8 V zurückgesetzt und etwa 46 µs nach dem Beginn der Simulation wieder auf den Einschaltwert 20 V erhöht. Etwa 59 µs nach dem Beginn der Simulation überschreitet die Gate-Spannung U2 ein weiteres Mal den Einschaltwert 20 V so deutlich, dass die von dem pnp-Bipolartransistor Q3 und dem npn-Bipolartransistor Q4 der Schutzschaltung 9 gebildete Thyristorstruktur zündet und der Halbleiterschalter 3 ein weiteres Mal abgeschaltet wird. Im Unterschied zu der in FIG 8 gezeigten Simulation bleibt die Gate-Spannung U2 bei der in FIG 10 gezeigten Simulation nach dem zweiten Erhöhen des Treibersignal U1 auf den Einschaltwert 20 V nicht negativ ("rastet nicht ein"), sondern steigt wieder an, weil der vierte Widerstand R4 nicht wie in FIG 7 sondern gemäß FIG 9 geschaltet ist.

FIG 10 zeigt, dass die in FIG 9 gezeigte Schutzschaltung 9 eine temporäre Abschaltung des Halbleiterschalters 3 für einen Schaltzyklus des Gate-Treibers 7 durch das Zünden der Bipolartransistoren Q3, Q4 der Schutzschaltung 9 bewirkt, wenn der Halbleiterschalter 3 während des Schaltzyklus an seine Entsättigungsgrenze kommt. Ferner zeigt FIG 10, dass eine erfindungsgemäße Schutzschaltung 9 auch in Verbindung mit einem Gate-Treiber 7 funktioniert, der eine Endstufe 14 mit komplementären Endstufen-MOSFET M1 bis M4 statt eine Gegentaktendstufe 13 mit Endstufen-Bipolartransistoren Q1, Q2 aufweist.

Die anhand der Figuren 1 bis 8 beschriebenen Ausführungsbeispiele können analog zu dem anhand der Figuren 9 und 10 beschriebenen Ausführungsbeispiel ebenfalls mit einem Gate-Treiber 7 ausgeführt werden, der eine Endstufe 14 mit komplementären Endstufen-MOSFET M1 bis M4 statt eine Gegentaktendstufe 13 mit Endstufen-Bipolartransistoren Q1, Q2 aufweist. Die in den Figuren 1 bis 10 gezeigten Ausführungsbeispiele können ferner abgewandelt werden, indem statt eines IGBT ein MOSFET als Halbleiterschalter 3 verwendet wird.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schutzschaltung (9) für einen Halbleiterschalter (3) mit einem durch einen Gate-Treiber (7) ansteuerbaren Gate (5), die Schutzschaltung (9) umfassend
- eine Klemmdiode (D2),
- einen npn-Bipolartransistor (Q4),
- einen pnp-Bipolartransistor (Q3),
- einen Kondensator (C1),
- einen ersten Widerstand (R5),
- einen zweiten Widerstand (R2) und
- einen dritten Widerstand (R4), wobei
- der Kollektor des npn-Bipolartransistors (Q4) mit der Basis des pnp-Bipolartransistors (Q3) verbunden ist,
- die Basis des npn-Bipolartransistors (Q4) mit dem Kollektor des pnp-Bipolartransistors (Q3) verbunden ist,
- der Emitter des pnp-Bipolartransistors (Q3) mit der Kathode der Klemmdiode (D2) verbunden ist,
- der erste Widerstand (R5) parallel zu der Basis-Emitter-Strecke des npn-Bipolartransistors (Q4) geschaltet ist,
- ein erster Pol des zweiten Widerstands (R2) mit der Basis des pnp-Bipolartransistors (Q3) verbunden ist,
- der Kondensator (C1) parallel zu der Basis-Emitter-Strecke des pnp-Bipolartransistors (Q3) geschaltet ist, und
- der dritte Widerstand (R4) entweder parallel zu der Basis-Emitter-Strecke des pnp-Bipolartransistors (Q3) geschaltet ist oder
- ein erster Pol (R4_1) des dritten Widerstands (R4) mit dem Emitter des pnp-Bipolartransistors (Q3) verbunden ist und der zweite Pol (R4_2) des dritten Widerstands (R4) mit dem zweiten Pol (R2_2) des zweiten Widerstands (R2) verbunden ist.

2. Schutzschaltung (9) nach Anspruch 1 mit einem vierten Widerstand (R7), der mit der Anode der Klemmdiode (D2) verbunden ist.

3. Schutzschaltung (9) nach Anspruch 1 oder 2 mit einer Zusatzdiode (D1), deren Kathode entweder direkt oder über einen fünften Widerstand (R6) mit dem Emitter des pnp-Bipolartransistors (Q3) und der Kathode der Klemmdiode (D2) verbunden ist.

4. Schutzschaltung (9) nach einem der vorhergehenden Ansprüche, wobei die Klemmdiode (D2) eine Schottky-Diode ist.

5. Schaltungsanordnung (1), umfassend
- einen Halbleiterschalter (3) mit einem Gate (5),
- einen Gate-Treiber (7) zum Ansteuern des Gate (5), wobei der Gate-Treiber (7) eine durch eine Treiberspannung des Gate-Treibers (7) steuerbare elektronische Schalteinheit (11) aufweist, mit der das Gate (5) zum Einschalten des Halbleiterschalters (3) über einen Einschalt-Gatewiderstand (R1, R8) mit einem Einschaltpotential und zum Ausschalten des Halbleiterschalters (3) über einen Ausschalt-Gatewiderstand (R1,R9) mit einem Ausschaltpotential verbunden wird, und
- eine Schutzschaltung (9) nach einem der vorhergehenden Ansprüche.

6. Schaltungsanordnung (1) nach Anspruch 5, wobei der Emitter des npn-Bipolartransistors (Q4) mit dem Ausschaltpotential verbunden ist und der zweite Pol (R2_2) des zweiten Widerstands (R2) mit dem Einschaltpotential verbunden ist.

7. Schaltungsanordnung (1) nach Anspruch 5 oder 6, wobei die Anode der Klemmdiode (D2) mit dem Gate (5) verbunden ist.

8. Schaltungsanordnung (1) nach Anspruch 5 oder 6, wobei die Anode der Klemmdiode (D2) über einen vierten Widerstand (R7) mit dem Gate (5) verbunden ist.

9. Schaltungsanordnung (1) nach einem der Ansprüche 5 bis 8 mit einer Zusatzdiode (D1), deren Kathode mit dem Emitter des pnp-Bipolartransistors (Q3) und der Kathode der Klemmdiode (D2) verbunden ist und an deren Anode die Treiberspannung liegt.

10. Schaltungsanordnung (1) nach Anspruch 8 mit einer Zusatzdiode (D1), deren Kathode über einen fünften Widerstand (R6) mit dem Emitter des pnp-Bipolartransistors (Q3) und der Kathode der Klemmdiode (D2) verbunden ist und an deren Anode die Treiberspannung liegt.

11. Schaltungsanordnung (1) nach einem der Ansprüche 5 bis 10, wobei der Einschalt-Gatewiderstand (R1) und der Ausschalt-Gatewiderstand (R1) identisch sind.

12. Schaltungsanordnung (1) nach einem der Ansprüche 5 bis 10, wobei zwischen den Einschalt-Gatewiderstand (R8) und den Gate-Treiber (7) eine Vorschaltdiode (D4) geschaltet ist, deren Kathode mit dem Einschalt-Gatewiderstand (R8) verbunden ist.

13. Schaltungsanordnung (1) nach einem der Ansprüche 5 bis 12, wobei der Halbleiterschalter (3) ein Bipolartransistor mit isolierter Gate-Elektrode oder ein Metall-Oxid-Halbleiter-Feldeffekttransistor ist.

14. Schaltungsanordnung (1) nach einem der Ansprüche 5 bis 13, wobei die elektronische Schalteinheit (11) des Gate-Treibers (7) eine Gegentaktendstufe (13) mit Endstufen-Bipolartransistoren (Q1,Q2) aufweist.

15. Schaltungsanordnung (1) nach einem der Ansprüche 5 bis 13, wobei die elektronische Schalteinheit (11) des Gate-Treibers (7) eine Endstufe (14) mit komplementären Endstufen-Metall-Oxid-Halbleiter-Feldeffekttransistoren (M1 bis M4) aufweist.
